# EUROPEAN PATENT APPLICATION

(11) **EP 1 316 977 A2**
(43) Date of publication of application: **04.06.2003**
(21) Application number: 02258280.3
(22) Date of filing: 29.11.2002
(51) Int. Cl.: H01H 1/00, F03G 7/06

(54) **Micromechanical actuator**

(30) Priority: 30.11.2001 US 997955
(71) Applicant: Nortel Networks Limited, St.Laurent, Québec H45 2A9 (CA)
(72) Inventor: Janssen, Adrien, Exeter, Devon EX4 2AF (GB); Rees, Martin, Paignton, Devon TQ4 7SN (GB); Pollard, Mark R., Plymouth, Devon PL6 5RD (GB)
(74) Representative: Anderson, Angela

(57) **Abstract**

A MEMS actuator 1 comprising an actuator member 2 operably engaged by at least one actuator beam 4 and heating means 12 for heating the or each beam 4. The heating may cause expansion of the or each beam 4, wherein the or each beam 4 has two ends A, A' and the or each beam 4 is fixed at only one end A and wherein the expansion effects movement of the actuator member 2. The heating may cause thermal expansion of the beam 4 in one direction and longitudinal displacement of the beam 4 in the direction of thermal expansion, which longitudinal displacement effects movement of the actuator member 2. The beam 4 may act on the member 2 at a position in relation to a pivot point P so as to produce a torque which effects pivoting of the member 2 about the pivot point P. The actuator may have at least two actuator beams 4 and heating the at least two beams 4 may cause simultaneous expansion of the at least two beams 4, which simultaneous expansion effects movement of the actuator member 2. Alternatively, heating one of the at least two beams 4 may cause differential expansion of the at least two beams 4, which differential expansion effects movement of the actuator member 2. The actuator may have at least two actuator members 202 operably engaged by at least one actuator beam 204 and heating the or each beam 204 may cause expansion of the or each beam 204, which expansion effects differential movement of the at least two members 202 or bending of the at least two members 202.

## Description

### TECHNICAL FIELD

The invention relates to microelectromechanical systems (MEMS) actuators and to methods of operating such actuators.

### BACKGROUND OF THE INVENTION

MEMS are now in widespread use. For example, in optical communications networks MEMS are used in switching and attenuation devices. A typical optical network MEMS switch has an array of mirrors each actuated by a MEMS actuator. Each mirror may be at a crossover point in the switch and may dictate to which of, say, two output ports a free space light beam from an input port will be diverted. A typical optical network attenuator has an array of shutters each actuated by a MEMS actuator. Each shutter may be brought into the path of a free space beam and the extent of actuation may determine the degree of attenuation.

US 6114794 (Dhuler et al) discloses a MEMS actuator of the type suitable for use in, for example, an optical network switch or attenuator. Dhuler et al propose a thermally actuated actuator comprising a metallic arched actuator beam extending between two spaced apart supports. The beam is fixed and constrained at each of its ends by the corresponding support. The actuator also comprises a separate heater for heating the beam thereby to cause it to expand and, because of the fixing at each end, it displaces transversely. The transverse displacement of the beam effects movement of an actuator member.

A difficulty with actuators of the construction disclosed by Dhuler et al is that the beams have to be flexible under thermally produced buckling stress and are therefore designed with multi-digitated elements. The necessary flexibility of the elements means that that, individually, they may not be capable of supporting relatively large load; by having multi-digitated elements, the load is spread and each element supports within its capabilities.

Alternatively, MEMS actuators may be electrostatically rather than thermally actuated, but large voltages are required to produce significant displacements of an actuator beam, and the forces and voltages involved may be non-linear.

### OBJECT OF THE INVENTION

It is an object of the invention to overcome disadvantages associated with known devices.

An object of the invention is to provide an improved MEMS actuator.

The above objects are met by the combination(s) of features of the main claim(s), the sub-claims disclose further advantageous embodiments of the invention.

### BRIEF DESCRIPTION OF THE INVENTION

According to a first aspect, the invention provides a MEMS actuator comprising an actuator member (2) operably engaged by at least one actuator beam (4a) and means for heating the beam in order to cause thermal expansion of the beam to effect movement of the actuator member.

The beam may have two ends and be fixed at only one end. The thermal expansion may cause longitudinal displacement of the beam in the direction of thermal expansion, which longitudinal displacement effects movement of the actuator member.

Fixing the beam at only one end means that the other end is not constrained. Thus, expansion of the beam is not bound to result in its transverse displacement. Moreover, the beam is permitted to displace longitudinally and it is this longitudinal displacement which may be utilised to effect movement of the actuator member.

The MEMS actuator may comprise an actuator member operably engaged by at least two actuator beams. It may further comprise means for heating the at least two beams thereby to cause simultaneous expansion of the at least two beams, which simultaneous expansion effects movement of the actuator member.

The or each beam may be electrically conductive such that passing a current through the or each beam heats the or each beam thereby to cause expansion of the or each beam, which expansion effects movement of the actuator member.

Having an electrically conductive beam means that the heating required to cause expansion of the beam may be brought about by resistive or joule heating on passing a current. Hence, the beam may be thermally actuated without the need for a separate thermal or heat source. For example, the or each beam may be fabricated from a highly doped semiconductor material such as silicon. Contacts may be made on the material at the relevant locations in order that a voltage may be applied across the beam. Other components of the actuator, such as the actuator member and a base part on which the or each beam may be supported may also be fabricated from semiconductor material; indeed, the same wafer of semiconductor material.

The MEMS actuator may comprise means for heating at least one of the two beams thereby to cause differential expansion of the at least two beams, which differential expansion effects movement of the actuator member.

The MEMS actuator may comprise a pivot point (p) which supports the actuator member (102), wherein the at least one actuator beam (104) acts on the member at position in relation to the pivot point such as to produce a torque which effects pivoting of the member about the pivot point.

The MEMS actuator may comprise at least two actuator members (202) operably engaged by at least one actuator beam (204) wherein the expansion of said at least one beam effects differential movement of the at least two members.

The MEMS actuator may comprise at least two actuator members operably engaged by at least one actuator beam, wherein the expansion effects bending of at least two members.

According to a second aspect, the invention provides a MEMS device incorporating a MEMS actuator according to the first aspect of the invention.

According to a third aspect, the invention provides a node in an optical communications network comprising a MEMS device incorporating a MEMS actuator according to the first aspect of the invention.

According to a fourth aspect, the invention provides a method of operating a MEMS actuator comprising an actuator member operably engaged by at least one actuator beam, the method comprising heating the or each beam thereby to cause expansion of the or each beam, which expansion effects movement of the actuator member.

The method may further comprise heating the or each beam thereby to cause thermal expansion of the beam in one direction and longitudinal displacement of the beam in the direction of thermal expansion, which longitudinal displacement effects movement of the actuator member.

The or each beam may be electrically conductive and the method may further comprise passing a current through the or each beam to heat the or each beam thereby to cause expansion of the or each beam, which expansion effects movement of the actuator member.

The method may further comprise an actuator member operably engaged by at least two actuator beams, the method comprising heating the at least two beams thereby to cause simultaneous expansion of the at least two beams, which simultaneous expansion effects movement of the actuator member.

The method may further comprise an actuator member operably engaged by at least two actuator beams, the method comprising heating at least one of the at least two beams thereby to cause differential expansion of the at least two beams, which differential effects movement of the actuator member.

The method may further comprise an actuator member supported at a pivot point and at least one actuator beam acting on the member, the method comprising heating the or each beam thereby to cause expansion of the or each beam, wherein the beam acts on the member at a position in relation to the pivot point such as to produce a torque which effects pivoting of the member about the pivot point.

The method may further comprise at least two actuator members operably engaged by at least one actuator beam, the method comprising heating the or each beam thereby to cause expansion of the or each beam, which expansion effects differential movement of the at least two members.

The method may further comprise at least two actuator members, operably engaged by at least one actuator beam, the method comprising heating the or each beam thereby to cause expansion of the or each beam, which expansion effects bending of the at least two members.

The summary of the invention does not necessarily disclose all the features essential for defining the invention; the invention may reside in a sub-combination of the disclosed features.

### BRIEF DESCRIPTION OF THE DRAWINGS

Figure 1 is a schematic side view of one embodiment of a MEMS actuator according to one aspect of the invention;
Figure 2 is a schematic side view of an alternative embodiment of a MEMS actuator according to one aspect of the invention;
Figure 3 is a schematic side view of one embodiment of a MEMS actuator according to one other aspect of the invention;
Figure 4 is a schematic side view of an alternative embodiment of a MEMS actuator according to one other aspect of the invention;
Figure 5 is a schematic side view of another alternative embodiment of a MEMS actuator according to one other aspect of the invention;
Figure 6 is a schematic side view of one embodiment of a MEMS actuator according to yet one other aspect of the invention; and
Figure 7 is a schematic illustration of a node in optical communications networks incorporating a MEMS actuator according to an aspect of the invention.

### DESCRIPTION OF THE INVENTION

The following description is of preferred embodiments by way of example only and without limitation to the combination of features necessary for carrying the invention into effect.

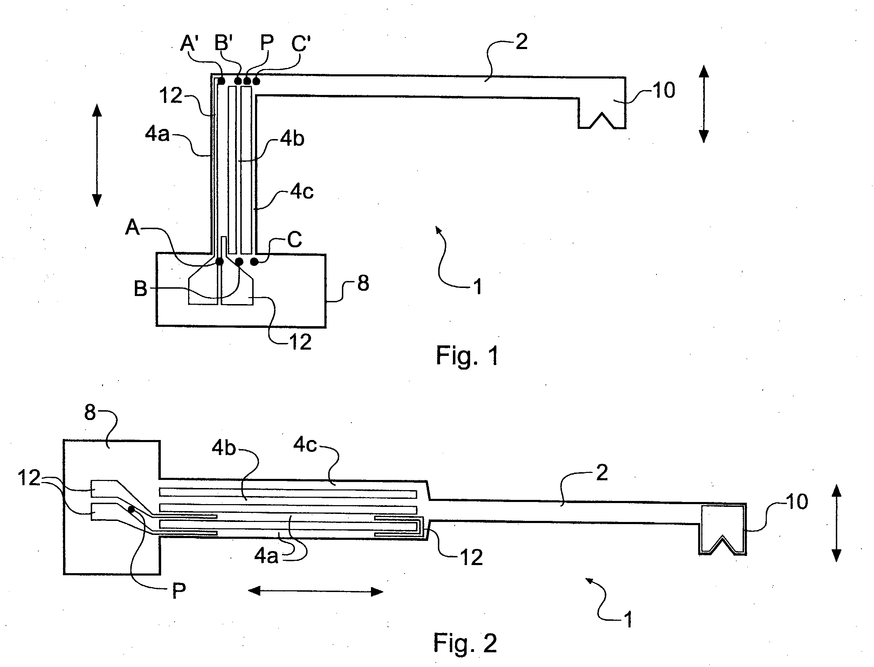

With reference to figure 1, an exemplary embodiment of one aspect of the invention will be described in the context of an optical signal attenuator indicated generally at 1, having a base part 8, three actuator beams 4a, 4b, 4c, each fixed at one end at a point A, B, C to the base part 8, and an actuator member 2, operably engaged with the other ends of the beams 4a, 4b, 4c at points A', B', C'. At the opposite end of the member 2, a shutter 10 is attached.

In use, by movement of the member 2, the shutter 10 is brought into and out of the path of a free space light beam (not shown); the degree of attenuation is determined by the extent to which the shutter 10 cuts the beam. The movement of the member 2 is effected by differential expansion of the three beams 4a, 4b, 4c, that is to say, one beam 4a is caused to expand whilst the other two beams 4b, 4c are not. The two non-expanding beams 4b, 4c, by virtue of their points of engagement B', C' to the member 2, in effect define a pivot point P. The point of engagement A' of the expanding beam 4a to the member 2 is the point at which the beam 4a acts upon member 2. The differential expansion results in the expanding beam 4a acting upon the member 2 thereby to produce a torque which effects pivoting of the member 2 about the pivot point P. In other words, as the expanding beam 4a expands and contracts, whilst the two non-expanding beams 4b, 4c remain relatively stable, the member 2 see-saws about the pivot point P causing the shutter 10 to go up and down.

The base part 8, beams 4 and member 2 are all micromachined out of highly doped silicon, such that the points of engagement A', B', C' of the beams 4 with the member 2 are actually continuous. Metal contacts 12 are applied to the expandable beam 4a so that a current may be induced to flow longitudinally along the beam 4a. The current results in resistive heating of the beam 4a causing it to expand longitudinally. Specifically, because the beam 4a is fixed at only one end to the base part 8, the beam is displaced longitudinally and it is this longitudinal expansion upon which the actuation of the member 2 depends. In other words, the beam 4a is displaced in the direction of expansion. This is in contrast to prior art arrangements where the beam displacement was substantially perpendicular to the direction of expansion. The degree of longitudinal expansion will depend upon its length, the resistance of the beam 4a, as partly dictated by its dimensions, and the current induced.

A further exemplary embodiment of this first, one aspect of the invention is shown in figures 2. This embodiment has two, rather than one, expandable beams 4a, the member 2 is parallel to, rather than perpendicular to, the beam 4, there is a virtual pivot point P and the current path between the contacts 12 is separated between the two beams, but the principle of operation is otherwise as described with reference to figure 1. The advantage of separating the current paths is that one of the contacts 12 does not need to extend along the full length of one of the beams 4a.

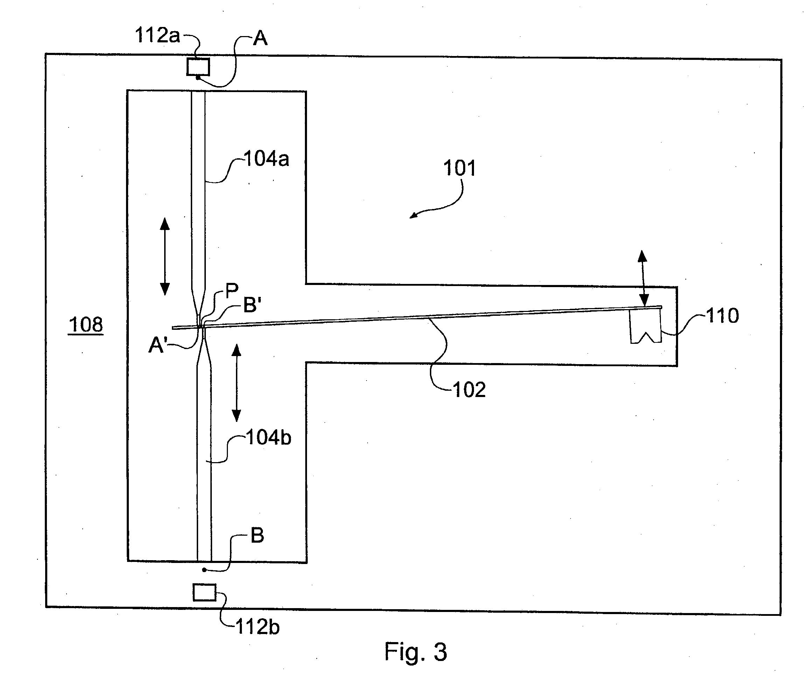

With reference to figure 3, an exemplary embodiment of another aspect of the invention will be described in the context of another optical signal attenuator indicated generally at 101, including a base part 108, two opposed actuator beams 104a, 104b each fixed at one end A, B respectively to the base part 108, and an actuator member 102 operably engages the other ends A', B' of the beams 104a, 104b. The member 102 and the beams 104a, 104b are micromachined from highly doped silicon, and, at the ends A', B', the beams 104a, 104b are in electrical contact with the member 102. At the remote end of the member 102, a shutter 110 is attached. Two metal contacts 112a, 112b are applied to the base 108, one each opposite the beam ends A and B respectively.

The beams 104a, 104b by virtue of their points of engagement with the member 102 in effect define a pivot point P. The movement of the member 102 is effected by the simultaneous expansion of the two beams 104a, 104b. The expansion of the two beams is caused by resistive heating of the two beams 104a, 104b as a result of current flowing between the contacts 112a and 112b as a result of the current path made by the beams 104a, 104b and the intervening part of the member 102. The simultaneous expansion results in the two beams 104a, 104b acting on the member 102 at the points of engagement A' and B' respectively thereby producing a torque about pivot point P. In other words, as the beams 104a, 104b simultaneously expand and contract, the member 102 see-saws about the pivot point P causing the shutter 110 to go up and down.

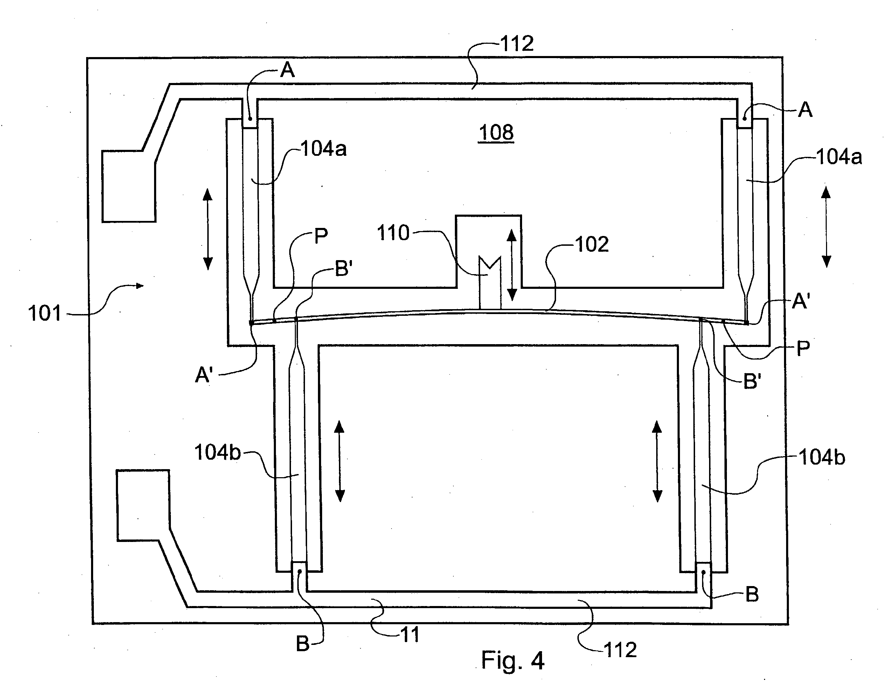

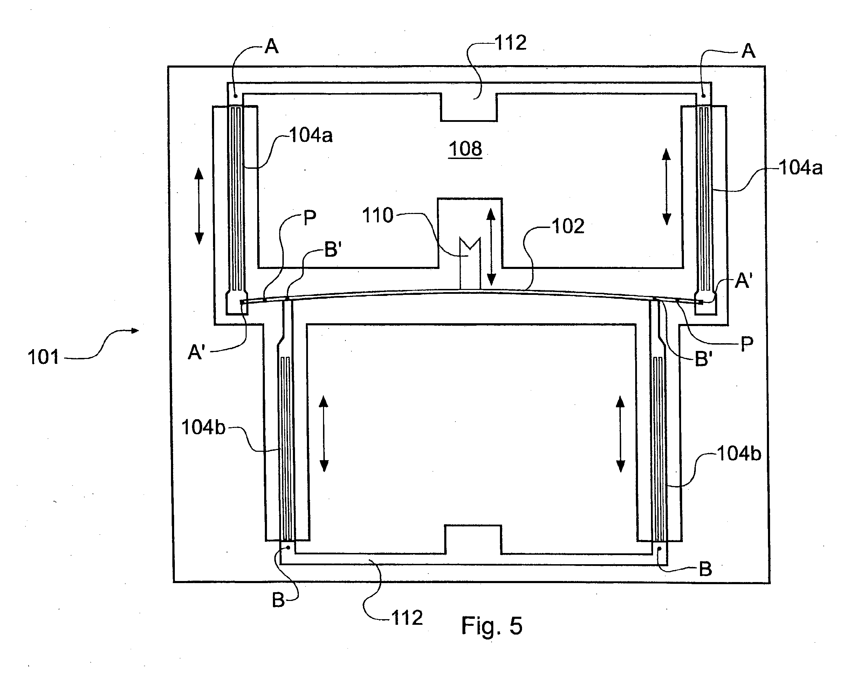

Further exemplary embodiments of this other aspect of the invention are shown in figures 4 and 5.

The optical signal attenuator 101 illustrated in figure 4 has two sets of simultaneously acting beams 104, with each set acting at one end of the member 102 such that simultaneous expansion of all the beams 4 results in an arching of the member 102. This arching means there is a transverse displacement of the member 102 at its centre which can be utilised to move a shutter 110.

The optical signal attenuator 101 illustrated in figure 5 is identical to the embodiment illustrated in figure 4 except that each beam 104 in each set is divided longitudinally into individual sub-beams. The selection of number and size of the beam 104 or sub-beams 104 is a matter of balancing the mechanical and heating characteristics of the beams 104.

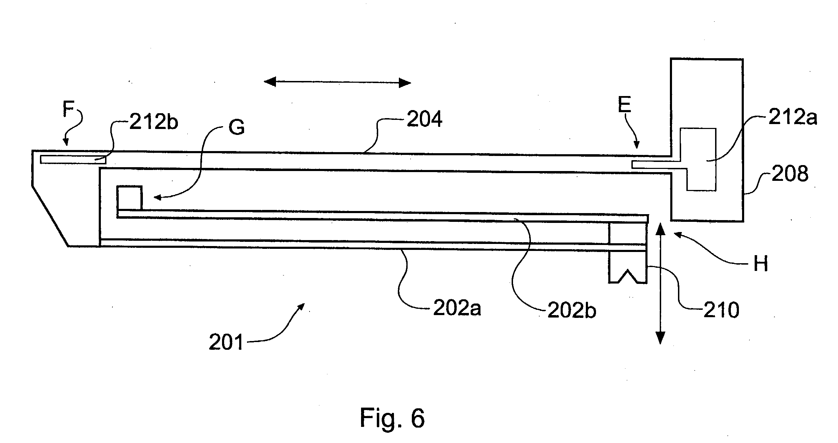

With reference to figure 6, an exemplary embodiment of yet another aspect of the invention will be discussed in the context of yet another optical signal attenuator indicated generally at 201, including a base part 208, an actuator beam 204, fixed at one end E to the base part 208 and being generally L-shaped at the opposite end F, and one 202a of two actuator members 202a, 202b is operably engaged by the L-shaped end F of the beam 204. The second 202b of the two actuator members 202a, 202b, which extends parallel to the first member 202a, is fixed at one end G, nearest to the L-shaped end F of the beam 204. The members 202a, 202b and the beam 204 are micromachined from highly doped silicon. At the remote ends H of the members 202, a shutter 210 is attached. Two metal contacts 212a, 212b are applied to opposite ends E, F of the beam 204 respectively.

In use, differential movement of the members 202a, 202b effects movement of the shutter 210 into and out of a free space light beam (not shown); the degree of attenuation is determined by the extent to which the shutter 210 cuts the beam. Differential movement of the members 202a, 202b, that is to say movement of one member 202a relative to the other member 202b, is effected by longitudinal expansion of the beam 204, brought about by passing a current between the two contacts 212a, 212b, which "pulls" or forces the beam 202a in the longitudinal direction, away from the shutter 210; because the second beam 202b is fixed at its end E and because the beams 202a, 202b are co-fixed at their remote ends H to the shutter 210, the puuling results in bending of the beams 202a, 202b, causing the shutter to move vertically.

The advantages of this embodiment are: i) its actuation efficiency in terms expansion required per degree of movement of the shutter partly because of the physical separation of the beam and the members which enables the members to be kept relatively cool whilst the beam is being heated; ii) the compact nature of the beam/member arrangement allows the actuator to be arrayed in an attenuation device with relatively narrow spacing between attenuators thereby minimising space requirements.

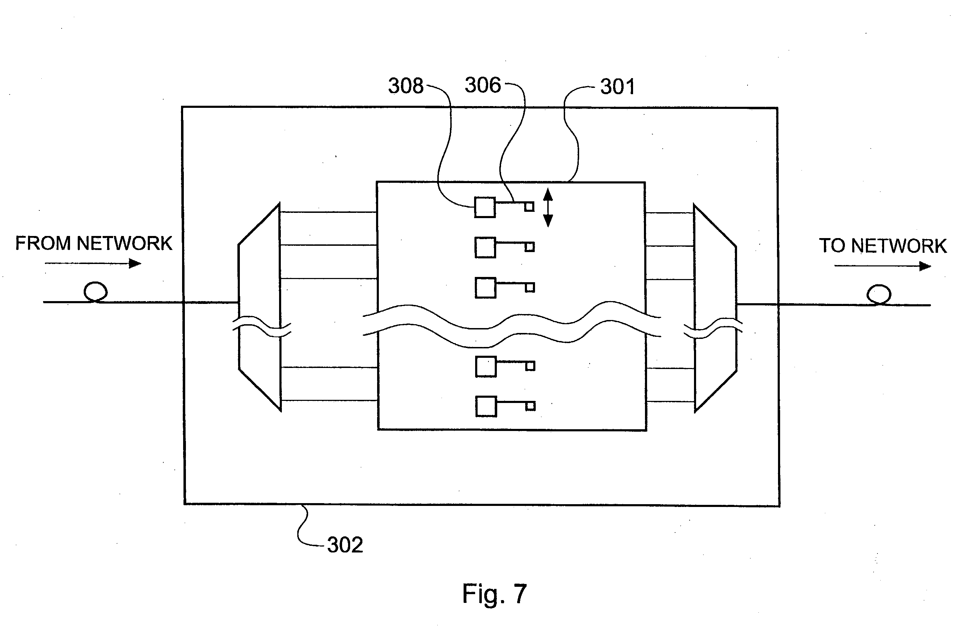

With reference to figure 7, any of the embodiments described with reference to figures 1 to 5 may be utilised in an optical attenuator 301, as an example of a MEMS device, at a node 302 in an optical communications network. The attenuator 301 may comprise a number of shutters 305, corresponding to the number of channels involved in the network, each operated by a separate MEMS actuator 308.

In summary the invention is directed to a MEMS actuator 1 comprising an actuator member 2 operably engaged by at least one actuator beam 4 and heating means 12 for heating the or each beam 4. The heating may cause expansion of the or each beam 4, wherein the or each beam 4 has two ends A, A' and the or each beam 4 is fixed at only one end A and wherein the expansion effects movement of the actuator member 2. The heating may cause thermal expansion of the beam 4 in one direction and longitudinal displacement of the beam 4 in the direction of thermal expansion, which longitudinal displacement effects movement of the actuator member 2. The beam 4 may act on the member 2 at a position in relation to a pivot point P so as to produce a torque which effects pivoting of the member 2 about the pivot point P. The actuator may have at least two actuator beams 4 and heating the at least two beams 4 may cause simultaneous expansion of the at least two beams 4, which simultaneous expansion effects movement of the actuator member 2. Alternatively, heating one of the at least two beams 4 may cause differential expansion of the at least two beams 4, which differential expansion effects movement of the actuator member 2. The actuator may have at least two actuator members 202 operably engaged by at least one actuator beam204 and heating the or each beam 204 may cause expansion of the or each beam 204, which expansion effects differential movement of the at least two members 202 or bending of the at least two members 202.

## Claims

1. A MEMS actuator comprising an actuator member (2) operably engaged by at least one actuator beam (4a) and means for heating the beam in order to cause thermal expansion of the beam to effect movement of the actuator member.

2. A MEMS actuator as claimed in claim 1 wherein the or each beam has two ends and the or each beam is fixed at only one end.

3. A MEMS actuator as claimed in any of the preceding claims wherein the thermal expansion causes longitudinal displacement of the beam in the direction of thermal expansion, which longitudinal displacement effects movement of the actuator member.

4. A MEMS actuator as claimed in any of the preceding claims comprising an actuator member operably engaged by at least two actuator beams.

5. A MEMS actuator as claimed in claim 4 comprising means for heating the at least two beams thereby to cause simultaneous expansion of the at least two beams, which simultaneous expansion effects movement of the actuator member.

6. A MEMS actuator as claimed in claim 4 comprising means for heating at least one of the at least two beams thereby to cause differential expansion of the at least two beams, which differential expansion effects movement of the actuator member.

7. A MEMS actuator as claimed in claim 1 or claim 2 comprising a pivot point (p) which supports the actuator member (102), wherein the at least one actuator beam (104) acts on the member at a position in relation to the pivot point such as to produce a torque which effects pivoting of the member about the pivot point.

8. A MEMS actuator as claimed in claim 1 comprising at least two actuator members (202) operably engaged by at least one actuator beam (204), wherein the expansion of said at least one beam effects differential movement of the at least two members.

9. A MEMS actuator as claimed in claim 1 comprising at least two actuator members operably engaged by at least one actuator beam, wherein the expansion effects bending of the at least two members.

10. A MEMS device incorporating a MEMS actuator according to any of the preceding claims.

11. A node in an optical communications network comprising a MEMS device according to claim 10.

12. A method of operating a MEMS actuator comprising an actuator member operably engaged by at least one actuator beam, the method comprising heating the or each beam thereby to cause expansion of the or each beam, which expansion effects movement of the actuator member.

13. A method of operating a MEMS actuator as claimed in claim 12 wherein the or each beam has two ends and the or each beam is fixed at only one end.

14. A method of operating a MEMS actuator as claimed in claim 12 or claim 13 comprising heating the or each beam thereby to cause thermal expansion of the beam in one direction and longitudinal displacement of the beam in the direction of thermal expansion, which longitudinal displacement effects movement of the actuator member.

15. A method of operating a MEMS actuator as claimed in any of claims 12-14 wherein the or each beam is electrically conductive, the method comprising passing a current through the or each beam to heat the or each beam thereby to cause expansion of the or each beam, which expansion effects movement of the actuator member.
